# EUROPEAN PATENT SPECIFICATION

(11) **EP 3 044 287 B1**
(45) Date of publication and mention of the grant of the patent: **12.09.2018**
(21) Application number: 14767069.9
(22) Date of filing: 11.09.2014
(51) Int. Cl.: C09K 11/54, C01G 9/02, C01G 11/00, C01G 13/02

(54) **SYNTHESIS OF METAL OXIDE SEMICONDUCTOR NANOPARTICLES FROM A MOLECULAR CLUSTER COMPOUND**
SYNTHESE VON METALLOXIDHALBLEITERNANOPARTIKELN AUS EINER MOLEKULAREN CLUSTERVERBINDUNG
SYNTHÈSE DE NANOPARTICULES DE MÉTAL-OXYDE-SEMI-CONDUCTEUR À PARTIR D'UN COMPOSÉ AGRÉGAT MOLÉCULAIRE

(30) Priority: 13.09.2013 US 201361877787 P
(43) Date of publication of application: 20.07.2016
(73) Proprietor: Nanoco Technologies Ltd, Manchester M13 9NT (GB)
(72) Inventor: PICKETT, Nigel, Manchester M20 6TR (GB); DANIELS, Steven Matthew, Derbyshire SK13 2AR (GB); MASALA, Ombretta, Manchester M14 6PE (GB); GRESTY, Nathalie, Chester CH3 5HG (GB)
(74) Representative: Dauncey, Mark Peter
(86) International application number: PCT/GB2014/052755
(87) International publication number: WO 2015/036762

(56) References cited:
- US-A1- 2008 220 593
- US-A1- 2011 068 322
- FABIEN GRASSET ET AL: "When "Metal Atom Clusters" Meet ZnO Nanocrystals: A ((n-C4H9)4N)2Mo6Br14@ZnO Hybrid", ADVANCED MATERIALS, vol. 20, no. 9, 5 May 2008 (2008-05-05), pages 1710-1715, XP055152121, ISSN: 0935-9648, DOI: 10.1002/adma.200701845

## Description

### BACKGROUND

### Field of the Invention.

The method relates to the synthesis of metal oxide quantum dots. In particular, the method relates to the synthesis of Group IIB oxide quantum dots using a II-VI cluster compound.

### Description of the Related Art.

Metal oxides semiconductors are of increasing technological interest in the electronics industry, for example, for use in field effect transistors (FETs) and transparent conducting oxides (TCOs). In particular, Group IIB oxides find use in laser diodes, as transparent conducting oxides, e.g. in photodiodes, photovoltaic cells, phototransistors, anti-reflective coatings, and in batteries.

Of the Group IIB oxides, heavy metal-free ZnO is of key interest for consumer products, owing to its non-toxic nature. Though there is some debate as to the exact band gap of ZnO (one study reported values in the range 3.10 - 3.26 eV, [F. Li, C. Liu, Z. Ma and L. Zhao, Optical Mater., 2012, 34, 1062] depending on the model of calculation, while another study reports a band gap of 3.28 eV at room temperature using a different method [A.P. Roth, J.B. Webb and D.F. Williams, Solid State Commun., 1981, 39, 1269]) its wide band gap and high optical gain at room temperature render ZnO a promising material for optoelectronic applications. Further, its ability to absorb UV radiation has been exploited for personal care applications such as sunscreens.

Quantum dots (QDs) are luminescent nanoparticles of semiconductor material, with diameters typically in the range of 1 to 20 nm. Their photo-absorption and -luminescence can be tuned by manipulating the particle size. The unique optical and electronic properties of QDs originate from quantum confinement effects; as the QD diameter decreases the electron and hole wavefunctions become quantum confined, giving rise to discrete energy levels similar to those observed in atoms or molecules, resulting in an increase in the semiconductor band gap with decreasing QD diameter.

As the particle size decreases, QD materials such as ZnO can become optically transparent, offering advantages for certain applications. For example, when used in sunscreens, ZnO QDs may offer the same level of UV absorption as larger ZnO nanoparticles, but without leaving a white residue on the skin. Further, the high absorption coefficient of QDs enables strong absorption from a tiny amount of material.

Methods to synthesize ZnO nanoparticles have been the subject of several reviews, with methods including plasma pyrolysis, combustion synthesis, precipitation reactions, citrate gel synthesis, micro-emulsion synthesis and sol-gel processing. [S.C. Pillai, J.M. Kelly, R. Ramesh and D.E. McCormack, J. Mater. Chem. C, 2013, 1, 3268] However, such methods often fail to manufacture nanoparticles with the small particle size and/or narrow size distribution and/or solubility properties required for QD applications.

The manufacture of ZnO nanoparticles in the QD regime, affording tunable absorption and emission characteristics with a narrow photoluminescence (PL) spectrum, requires a method to provide particles with a homogeneous morphology and size distribution. In 1993, Murray *et al.* reported the colloidal synthesis of cadmium chalcogenide QDs by injecting a cooler precursor solution into a warmer precursor solution above a critical temperature, to initiate particle growth [C.B. Murray, D.J. Norris and M.G. Bawendi, J. Am. Chem. Soc., 1993, 115, 8706]. The subsequent rapid cooling of the solution prevents further nucleation, and particle growth ensues at a lower temperature. This technique, known as "hot-injection," yields particles with a narrow size distribution when conducted on a lab-bench scale, and has been at the forefront of the development of QDs with desirable structural and optical properties. However, for gram-scale reactions or greater, the rapid injection of a large volume of one solution into another results in a temperature differential that compromises the particle size distribution. Thus, ongoing efforts are focused on developing commercially scalable synthetic techniques.
In an example of an injection-free technique, Omata *et al.* described the synthesis of 3 - 7 nm ZnO QDs *via* a combined hydrolysis and successive dehydration condensation reaction between zinc alkoxide and benzylamine. [T. Omata, K. Takahashi, S. Hashimoto, Y. Maeda, K. Nose, S. Otsuka-Yao-Matsuo and K. Kanaori, J. Colloid Interf. Sci., 2011, 355, 274] Though the method produced small, monodisperse nanoparticles with tunable absorption and emission (depending on the reaction temperature), it could only be conducted on a milligram scale.
Grasset *et al.* reported the preparation and characterization of a luminescent hybrid nanocomposite, ((*n*-C₄H₉)₄NhMo₆Br₁₄@ZnO [F. Grasset et al., Adv. Mater., 2008, 20, 1710].

Single-source precursor (SSP) nanoparticle synthesis involves the thermal decomposition of a precursor containing ions of the species to be incorporated into the nanoparticle. SSPs have been used to synthesize metal oxide nanoparticles. However, in the case of ZnO, SSP methods typically produce particles with dimensions beyond the QD regime. Further, the majority of prior art methods have not used SSPs to form ZnO in colloidal solutions, so the nanoparticles are often uncapped and thus cannot easily be dispersed in solution for ease of processability. For example, Palve and Garje described the synthesis of ZnO nanoparticles from the thermal decomposition of the SSPs ZnCl₂(benzsczH)₂ and ZnCl₂(cinnamsczH)₂, where (benzsczH)₂ = benzaldehyde semicarbazone and (cinnamsczH)₂ = cinnamaldehyde semicarbazone, in a furnace at 515°C. [A.M. Palve and S.C. Garje, Synth. React. Inorg., Met.-Org., Nano-Met. Chem., 2010, 40, 153] Though nanoparticle dimensions were confirmed by X-ray diffraction (XRD) and transmission scanning microscopy (TEM), the particles were considerably larger than QDs, on the order of 50 - 100 nm along the shortest axis, and with irregular plate-like morphologies. In addition, the nanoparticles were uncapped and are therefore poorly suited to solution-based processing methods. In another example, zinc oximato cluster compounds were used to form nanocrystalline ZnO under *chimie douce* conditions. [J.J. Schneider, R.C. Hoffmann, J. Engstler, A. Dilfor, A. Klyszcz, E. Erdem, P. Jakes and R.A. Eichel, J. Mater. Chem., 2009, 19, 1449] Though TEM revealed small grain sizes (on the order of 10 - 15 nm), ZnO was formed as a continuous film, rather than as discrete particles.

Smaller nanoparticles, on the order of quantum dots, have been described, but have thus far failed to meet the requirements for commercial solution-based deposition processes. Bury *et al.* described the synthesis of 2 nm ZnO nanoparticles from the decomposition of the SSP [(*^{t}*BuZnOH)₆] in toluene at 60°C, [W. Bury, E. Krajewska, M. Dulkiewicz, K.Sokolowski, I. Justyniak, Z. Kaszkur, K.J. Kurzydlowski, T. Plocinski and J. Lewinski, Chem. Commun., 2011, 47, 5467]. However the nanoparticles were not isolated from solution and were found to grow and aggregate upon the further application of heat. 2 - 10 nm ZnO nanoparticles have been formed on the surface of multi-wall carbon nanotubes, from the decomposition of a zinc oximato complex [2-(methoxyimino)propanato]zinc(II), at 150°C, [J. Khanderi, R.C. Hoffmann, A. Gurlo and J.J. Schneider, J. Mater. Chem., 2009, 19, 5039]. However the synthesis has so far not been reported *ex situ.*

In one example of the synthesis of ZnO nanoparticles using an SSP in a colloidal solution, 3.9 - 7 nm quantum dots were grown by the hot-injection of zinc ketoacidoximate/octylamine solution into trioctylamine at a range of temperatures between 110 - 200°C. [Y.S. Wang, J. Cryst. Growth, 2006, 291, 398] Similarly, Hambrock *et al.* described the hot-injection synthesis of 2 - 3 nm ZnO nanoparticles from the SSP [MeZnOSiMe₃]₄. [J. Hambrock, S. Rabe, K. Merz, A. Birkner, A. Wohlfart, R.A. Fisher and M. Driess, J. Mater. Chem., 2003, 13, 1731] Despite yielding surface-capped, solution processable nanoparticles, those hot-injection syntheses are difficult to scale to commercial volumes.

The synthesis of other Group IIB oxide nanoparticles is less well reported in the prior art. CdO is an *n*-type semiconductor, finding use in optoelectronic devices, phosphors, pigments, as a catalyst and in battery electrodes. 35 nm pseudo-spherical CdO nanoparticles have been fabricated by a photosynthetic route, involving the incubation of aqueous CdCl₂ solution in the presence of a plant (*Achillea wilhelmsii*) extract. [J.K. Andeani and S. Moheenzadeh, J. Chem., 2013, 147613] In the form of QDs, ∼ 9 nm CdO particles were prepared by a quenching method, following the sintering of CdO powder at 900°C in a muffle furnace. [H.S. Virk and P. Sharma, J. Nano Res., 2010, 10, 69] The QDs were uncapped and, therefore, most likely display poor solubility. As with CdO, HgO finds use in catalysis, pigments and battery electrodes. Edrissi *et al.* described two methods to form HgO nanoparticles. [M. Edrissi, M. Soleymani and S. Tajik, Mater. Technol., 2013, 28, 129] The first involved a solubility difference method to convert Mg(OH)₂, in the presence of HgCl₂ and oleic acid, to less soluble Hg(OH)₂, which decomposed to form 3.0 - 7.4 nm HgO nanoparticles under the reaction conditions. The second method involved the thermolysis of Hg(DDTT)₂ in a furnace to yield 2.4 - 4.8 nm particles. Though the former method generated capped nanoparticles, the size distribution was relatively large, which leads to poor uniformity in the optical properties of the particles. In the latter example, the particles were uncapped and would thus be expected to have poor solubility properties.

Thus, there is a need to provide a method of Group IIB oxide QD synthesis that can be scaled to commercial volumes, yielding isolable nanoparticles with good solubility and high performing optical characteristics.

### SUMMARY

Herein, a method of forming Group IIB metal oxide nanoparticles is described, wherein the nanoparticles are grown in a colloidal reaction solution in the presence of a II-VI molecular cluster compound. In some embodiments, the molecular cluster compound may be pre-fabricated. Alternatively, the molecular cluster compound may be generated *in situ.* The cluster compound may contain (i) ions of both the Group IIB metal and oxygen to be incorporated into the growing nanoparticles, (ii) ions of the Group IIB metal or oxygen, but not both, or (iii) neither ions of oxygen nor the Group IIB metal. The described method may be used to synthesize ZnO, CdO and HgO nanoparticles, including doped and alloyed species thereof.

During the preparative procedure, one or more precursors containing a Group IIB metal and oxygen may be added to the colloidal reaction solution. The colloidal reaction solution may include a Lewis base coordinating solvent, or a non-coordinating solvent in conjunction with a ligand to act as a capping agent. Optionally, an activating agent may be added to the colloidal reaction solution. The colloidal reaction solution is mixed at a first temperature, then heated to a second temperature, or range of temperatures, to initiate nanoparticle growth. The reaction solution is then maintained at elevated temperature to effect nanoparticle growth.

The resulting nanoparticles feature a metal oxide semiconductor layer disposed upon the molecular cluster compound. The nanoparticle shape is not restricted and may be a sphere, rod, disc, tetrapod, star or bullet, with a diameter in the range 1 - 100 nm. In certain embodiments the nanoparticles are quantum dots (QDs), with diameters in the range 1 - 20 nm, for example, 1 - 10 nm.

The foregoing summary is not intended to summarize each potential embodiment or every aspect of the present invention.

### BRIEF DESCRIPTION OF THE DRAWINGS

Figure 1 shows the UV-visible absorption and photoluminescence (PL) spectra of ZnO nanoparticles, synthesized in HDA in the presence of a zinc oximato cluster (Example 1).
Figure 2 shows a transmission electron microscopy (TEM) image of ZnO nanoparticles, synthesized in HDA in the presence of a zinc oximato cluster (Example 1), revealing pseudo-spherical particles with diameters < 10 nm, consistent with nanoparticles in the QD regime.
Figure 3 shows the UV-visible absorption spectrum of ZnO nanoparticles, synthesized in HDA/TOPO, using zinc(II) acetate and octanol precursors, in the presence of a zinc oximato cluster (Example 2).
Figure 4 shows the UV-visible absorption spectrum of ZnO nanoparticles, synthesized in HDA/TOPO, using zinc(II) acetate and octanol precursors, in the presence of a zinc oximato cluster (Example 3).
Figure 5 shows the X-ray diffraction (XRD) pattern of ZnO nanoparticles, synthesized in HDA/TOPO, using zinc(II) acetate and octanol precursors, in the presence of a zinc oximato cluster (Example 3), consistent with zincite phase ZnO. N.B. The low angle (2θ < 30°) reflections correspond to the capping agent.
Figure 6 shows the UV-visible absorption spectrum of ZnO nanoparticles, synthesized in HDA/TOPO in the presence of a zinc oximato cluster (Example 4).

### DESCRIPTION

The method described herein relates to the synthesis of Group IIB metal oxide nanoparticles, grown in a colloidal reaction solution in the presence of a II-VI molecular cluster compound, which acts as a seed. Herein, a molecular cluster should be understood to mean three or more metal atoms and their associated ligands, having a sufficiently well-defined chemical structure, such that all molecules of the cluster compound possess the same relative molecular formula. Thus, the molecular clusters are identical to one another and can be represented by a molecular formula.

The molecular cluster seeding method, as described in the Applicant's granted U.S. Patent No. 7,803,423, employs a precursor compound containing a first ion and a precursor compound containing a second ion, which react to form nanoparticles in the presence of a population of molecular cluster compounds. The molecular cluster compounds provide "seeds" or nucleation sites at which nanoparticle growth is initiated. As the molecular clusters are all identical (i.e., they all have the same molecular formula) the molecular cluster compounds provide a population of identical nucleation sites. The consistency of the nucleation sites result in a high degree of monodispersity of the resulting nanoparticles. The molecular cluster seeding method obviates the need for a high temperature nucleation step, as required in "hot-injection" techniques. The cluster acts as a template for nanoparticle growth. A key advantage of the molecular seeding method is that it can easily be scaled to produce commercial volumes of QDs, while maintaining a high degree of monodispersity and purity.

The molecular seeding method described herein can be used to synthesize nanoparticles in the QD size regime (1 - 20 nm), displaying quantum confinement effects. Thus, the method described herein facilitates the production of solution processable Group IIB oxide nanoparticles suitable for electronic device applications, both relatively cheaply and on a large scale. The metal oxide nanoparticles prepared as described herein have a metal oxide crystalline core disposed upon the molecular cluster compound.

In some embodiments, it is preferred that the molecular cluster compound and the resultant nanoparticles have compatible crystallographic phases, to permit the growth of said core nanoparticle material on said molecular cluster.

In some embodiments, the molecular cluster compound is prefabricated, prior to its addition to the reaction solution. In alternative embodiments, the molecular cluster compound is generated *in situ,* prior to the addition of precursors used to effect particle growth.

The conversion of the precursor(s) to the nanoparticle material can be conducted in any suitable solvent. In the case where the reaction proceeds *via* a molecular seeding route, it will be appreciated that it is important to maintain the integrity of the molecules of the cluster compound. Consequently, when the cluster compound and nanoparticle precursor(s) are introduced in to the solvent, the temperature of the solvent must be sufficiently high to ensure satisfactory dissolution and mixing of the cluster compound (it is desirable, but not necessary that the present compounds are fully dissolved), but not so high as to disrupt the integrity of the cluster compound molecules. Once the cluster compound and precursor composition are sufficiently well dissolved in the solvent, the temperature of the solution thus formed is raised to a temperature, or range of temperatures, which is/are sufficiently high to initiate nanoparticle growth. As the temperature is increased, further quantities of precursor may be added to the reaction in a dropwise manner, or as a solid or gas. The solution can then be maintained at this temperature or within this temperature range for as long as required to form nanoparticles possessing the desired properties.

A wide range of appropriate solvents is available. The particular solvent used is usually at least partly dependent upon the nature of the reacting species, i.e. nanoparticle precursor(s) and/or cluster compound, and/or the type of nanoparticles that are to be formed. Typical solvents include Lewis base-type coordinating solvents, such as a phosphine, e.g. trioctylphosphine (TOP), a phosphine oxide, e.g. trioctylophosphine oxide (TOPO), an amine, e.g. hexadecylamine (HDA), or a thiol, e.g. octanethiol, or non-coordinating organic solvents, e.g. alkanes and alkenes, polyelectrolytes such as poly(acrylic acid), polyalylamines, or diethylene glycol. If a non-coordinating solvent is used then the reaction will usually proceed in the presence of a further coordinating agent to act as a "capping agent".

The coordination about the final inorganic surface atoms in any nanoparticle is incomplete, with highly reactive non-fully coordinated atoms "dangling bonds" on the surface of the particle, which can lead to particle agglomeration. This problem is overcome by passivating (capping) the "bare" surface atoms with protecting organic groups. The outermost layer (capping agent) further helps to inhibit particle aggregation and provides protection from the surrounding chemical environment. In addition, it imparts solubility in specific solvents, facilitating processability of QDs into an ink or slurry that can be deposited by conventional printing or coating techniques, such as inkjet printing, spin coating, slit coating, doctor blading and the like.

For fluorescence applications, organically-capped colloidal QD cores generally display a low photoluminescence quantum yield (QY), due to exciton recombination via surface defects and dangling bonds. Modification of the structural and electronic architecture of the QDs, while maintaining control of the size-tunable band gap, can be achieved via the epitaxial growth of one or more "shell" layers of different band gap semiconductor material(s) on the nanoparticle surface. A core/shell architecture is achieved by the growth of a wider band gap material on the core surface, e.g. CdO/ZnO. Shelling serves to eliminate surface defects and dangling bonds to significantly improve the QY and enhance stability by suppressing interactions between charge carriers and the surrounding environment. Further improvements in stability can be achieved with additional shelling layers, as in the core/multishell structure, e.g. CdO/ZnSe/ZnO, a quantum dot-quantum well architecture, e.g. ZnO/CdO/ZnO, or a core/compositionally graded shell structure, e.g. CdO/Cd₁₋ₓZnₓSe_{1-y}O_{y}.

Optionally, QD synthesis may proceed in the presence of an activating agent to lower the decomposition temperature of the molecular cluster. Suitable activating agents include, but are not restricted to, alcohols, such as octanol, and amines, such as HDA. During the course of the reaction, particle growth can be monitored by taking aliquots from the reaction solution and measuring the UV-visible absorption and/or PL spectra.

The shape of the nanoparticles may consist of a sphere, rod, disc, tetrapod, star or bullet, but is not restricted to these. The nanoparticle shape can be controlled via any means known to one skilled in the art, such as by modifying the reaction ligands and/or processing conditions.

### Type of Systems

The method describes the synthesis of Group IIB metal oxide nanoparticles: ZnO, CdO and HgO, including doped species and alloys thereof. In one embodiment, the metal oxide (M¹O) nanoparticles are grown in the presence of a II-VI cluster where II = M¹ and VI = O. As used herein, the statement that II = M¹ means that the M contained within the molecular cluster is the same M as contained in the oxide MO. By way of a non-limiting example, ZnO nanoparticles can be grown in the presence of a cluster compound containing zinc and oxygen, such as diaquabis[2-(methoximino)propanato]zinc(II), [Zn(OC(O)C(Me)N(OMe))₂]·2H₂O.

In a second embodiment, the metal oxide nanoparticles are grown in the presence of a II-VI cluster where II = M¹ and VI ≠ O. By way of a non-limiting example, CdO nanoparticles can be grown in the presence of a cluster compound containing cadmium and sulphur, such as [Et₃NH]₄[Cd₁₀S₄(SPh)₁₆].

In a third embodiment, the metal oxide nanoparticles are grown in the presence of a II-VI cluster where II ≠ M¹ and VI = O. As used herein, the statement that II ≠ M¹ that the M contained within the molecular cluster is not the same M as contained in the oxide MO. By way of a non-limiting example, CdO nanoparticles can be grown in the presence of a cluster compound containing zinc and oxygen, such as diaquabis[2-(methoximino)propanato]zinc(II), [Zn(OC(O)C(Me)N(OMe))₂]·2H₂O.

In a fourth embodiment, the metal oxide nanoparticles are grown in the presence of a II-VI cluster where II ≠ M¹ and VI ≠ O. By way of a non-limiting example, HgO nanoparticles can be grown in the presence of a cluster compound containing cadmium and selenium, such as [Et₃NH]₄[Cd₁₀Se₄(SPh)₁₆].

In further preferred embodiments, the metal oxide nanoparticles are grown in the presence of a II-VI cluster, as described in embodiments 1 - 4, where the cluster contains ions of more than one Group IIB metal and/or more than one chalcogen to form doped or alloyed nanoparticles. Examples include, but are not restricted to, Zn₁₋ₓCdₓO and ZnO_{1-y}S_{y}.

In yet further preferred embodiments, the metal oxide nanoparticles are grown in the presence of a II-VI cluster, as described in embodiments 1 - 4, and in the presence of additional metal ions to form doped metal oxide nanoparticles. The dopant metal may be from Group IIB of the periodic table, but may also be from any other group. Examples of nanoparticle material include, but are not restricted to, ZnO:Al and CdO:In.

Optionally, one or more layers of semiconductor material may be grown epitaxially on the surface of the metal oxide nanoparticles to form a shell, to eliminate surface defects and dangling bonds in order to improve the fluorescence QY and enhance stability by suppressing interactions between charge carriers and the surrounding environment. The shell material(s) will, in most cases, be of a similar lattice type to the core material, i.e. each shell material will have close lattice match to the core material so that it can be epitaxially grown on to the core, but the shell materials are not necessarily restricted to this compatibility. The material(s) used for any shell(s) grown onto the core will, in most cases, have a wider band gap than the core material, but is/are not necessarily restricted to materials of this compatibility. Suitable shell materials include, but are not restricted to:
IIA-VIB (2-16) material, consisting of a first element from group 2 of the periodic table and a second element from group 16 of the periodic table, and also including ternary, quaternary and doped materials thereof. Nanoparticle material includes, but is not restricted to, MgS, MgSe, MgTe, CaS, CaSe, CaTe, SrS, SrSe, SrTe.
IIB-VIB (12-16) material consisting of a first element from group 12 of the periodic table and a second element from group 16 of the periodic table, and also including ternary, quaternary and doped materials thereof. Nanoparticle material includes, but is not restricted to, ZnO, ZnS, ZnSe, ZnTe, CdO, CdS, CdSe, CdTe, HgO, HgS, HgSe, HgTe.
II-V material consisting of a first element from group 12 of the periodic table and a second element from group 15 of the periodic table, and also including ternary, quaternary and doped materials thereof. Nanoparticle material includes, but is not restricted to, Zn₃N₂, Zn₃P₂, Zn₃As₂, Cd₃N₂, Cd₃P₂, Cd₃As₂.
III-V material consisting of a first element from group 13 of the periodic table and a second element from group 15 of the periodic table, and also including ternary, quaternary and doped materials thereof. Nanoparticle material includes, but is not restricted to, BN, BP, AlN, AlP, AlAs, AlSb, GaN, GaP, GaAs, GaSb, InN, InP, InAs, InSb.
III-IV material consisting of a first element from group 13 of the periodic table and a second element from group 14 of the periodic table, and also including ternary, quaternary and doped materials thereof. Nanoparticle material includes, but is not restricted to, B₄C, Al₄C₃, Ga₄C.
III-VI material consisting of a first element from group 13 of the periodic table and a second element from group 16 of the periodic table, and also including ternary, quaternary and doped materials thereof. Nanoparticle material includes, but is not restricted to, Al₂S₃, Al₂Se₃, Al₂Te₃, Ga₂S₃, Ga₂Se₃, Ga₂Te₃, In₂S₃, In₂Se₃, In₂Te₃.
IV-VI material consisting of a first element from group 14 of the periodic table and a second element from group 16 of the periodic table, and also including ternary, quaternary and doped materials thereof. Nanoparticle material includes, but is not restricted to, PbS, PbSe, PbTe, SnS, SnSe, SnTe.

Nanoparticle material consisting of a first element from the d-block of the periodic table and a second element from group 16 of the periodic table, and also including ternary, quaternary and doped materials thereof. Nanoparticle material includes, but is not restricted to, NiS, CrS, CuInS₂, CuInSe₂, AgInS₂.

In preferred embodiments, the outermost surface of the nanoparticles is capped with a layer of organic ligands, known as a "capping agent". The capping agent passivates the nanoparticle surface to eliminate surface defects and dangling bonds, and imparts solubility to thus facilitate solution processing of the nanoparticles. Such capping agents are typically Lewis bases, including mono- or multi-dentate ligands of the type phosphines (e.g. TOP, triphenolphosphine, *t*-butylphosphine), phosphine oxides (e.g. TOPO), alkyl phosphonic acids, alkylamines (e.g. HDA, octylamine), arylamines, pyridines, thiols (e.g. octanethiol), a long chain fatty acid, and thiophenes, but a wide range of other agents are available, such as oleic acid and organic polymers that form protective sheaths around the nanoparticles.

In particularly preferred embodiments, the method described herein is used to fabricate nanoparticles with a homogeneous shape and size distribution. The nanoparticle shape may consist of, but is not restricted to, a sphere, rod, disc, tetrapod, star or bullet. The nanoparticle morphology can be controlled using any means known to one skilled in the art, such as modification to the reaction conditions or ligand(s). In preferred embodiments, the nanoparticle diameter (along its shortest axis) lies in the range 1 - 100 nm, more preferably 1 - 20 nm, most preferably 1 - 10 nm.

### Description of the Preparative Procedure

In preferred embodiments, a pre-fabricated cluster compound is mixed with a high boiling solvent. In alternative preferred embodiments, appropriate precursors are added to the solvent to form a molecular cluster *in situ.* Where the reaction solvent is non-coordinating, a capping agent is added to the reaction solution. In some embodiments, additional metal and oxide precursors are added, either in the form of separate precursors or as a single-source precursor. Any suitable molar ratio of the molecular cluster material to the metal and oxide precursor(s) may be employed. Preferably, the molar ratio lies in the range 1:0 (i.e. no metal and oxide precursor(s) to 1:10,000, more preferably 1:0 to 1:1,000, and most preferably 1:0 to 1:250. Optionally, an activating agent is added to the reaction solution to lower the decomposition temperature of the cluster.

The reagents are stirred at a first temperature that is sufficiently low that no particle growth will occur. The solution is then heated, at a steady rate, to a second temperature at which particle growth is initiated. At an appropriate temperature, further quantities of the metal and oxide precursors may be added to sustain particle growth and to inhibit particles from being consumed via Ostwald's ripening. Once the desired particle size is obtained, the reaction is quenched by cooling the solution.

### Molecular Cluster Compound

The preparative procedure comprises the growth of Group IIB metal oxide nanoparticles in the presence of a II-VI molecular cluster compound. Examples of suitable molecular cluster compounds and their synthesis are described in U.S. Patent No. 7,803,423.

In one embodiment, the cluster compound contains the Group IIB metal (M) and oxygen (O) ions to be incorporated into the metal oxide (MO) nanoparticles.

In other embodiments, the cluster compound contains either Group IIB metal (M) or oxygen (O) ions to be incorporated into the metal oxide (MO) nanoparticles, but not both.

In a further embodiment, the cluster compound contains neither the Group IIB metal (M) or oxygen (O) ions to be incorporated into the metal oxide (MO) nanoparticles.

In some embodiments, the II-VI cluster contains oxygen. Examples of suitable cluster compounds include, but are not restricted to: oximato clusters, e.g. [Zn(OC(O)C(Me)N(OMe))₂]·2H₂O.

In other embodiments, the II-VI cluster contains sulfur. Examples of suitable cluster compounds include, but are not restricted to: [Et₃NH]₄[Cd₁₀S₄(SPh)₁₆]; [RMS^{t}Bu]₅ (R = Me, Et, Ph); [X]₄[S₄M₁₀(SR)₁₆] (X = Me₃NH⁺, Li⁺, Et₃NH⁺); [M₄(SPh)₁₂]⁺[X]₂⁻ (X = Me₄N⁺, Li⁺); [Zn(SEt)Et]₁₀; [MeMSiPr]; [O(ClO₃)CdSR]₅ (R = PPh₃, ⁱPr); [Cd₁₀S₄(EPh)₁₂(PR₃)₄] (E = S, Se, Te).

In further embodiments, the II-VI cluster contains selenium. Examples of suitable cluster compounds include, but are not restricted to: [Me₃NH]₄[Cd₁₀Se₄(SPh)₁₆], [Et₃NH]₄[Cd₁₀Se₄(SPh)₁₆]; [RMSe^{t}Bu]₅ (R = Me, Et, Ph); [X]₄[Se₄M₁₀(SR)₁₆] (X = Me₃NH⁺, Li⁺, Et₃NH⁺); [Hg₁₀Se₄(SePh)(PPh₂ⁿPr)₄]; [Hg₃₂Se₁₄(SePh)₃₆]; [Cd₁₀Se₄(SePh)₃₆(PPh₃)₄]; [MeMSeⁱPr]; [Cd₁₀Se₄(EPh)₁₂(PR₃)₄] (E = S, Se, Te); [Cd₈Se(SePh)₁₂Cl₄]²⁻; [Ph₁₂Se₁₈Cd₁₀(PEt₃)₃].

In further embodiments, the II-VI cluster contains tellurium. Examples of suitable cluster compounds include, but are not restricted to: [Hg₄Te₁₂][N(CH₂CH₂Et)₄]₄; [RMTe^{t}Bu]₅ (R = Me, Et, Ph); [X]₄[Te₄M₁₀(SR)₁₆] (X = Me₃NH⁺, Li⁺, Et₃NH⁺); [MeMTeⁱPr]; [Cd₁₀Te₄(EPh)₁₂(PR₃)₄] (E = S, Se, Te); [CdTe₁₂]⁴⁻; [HgTe₁₂]⁴⁻; [Ph₁₂Te₁₈Cd₁₀(PEt₃)₃].

### Metal Source

The Group IIB metal (M) precursor may include, but is not restricted to, an organometallic compound, an inorganic salt, a coordination compound, or an elemental source. Examples include, but are not restricted to: organometallic compounds of the form MR₂, where R = alkyl or aryl, e.g. ZnEt₂, CdMe₂, HgMe₂; inorganic salts such as fluorides, chlorides, bromides, iodides, and nitrates (M(NO₃)₂; coordination compounds such as carbonates (MCO₃), acetates (M(CH₃CO₂)₂), acetylacetonates (M(CH₃C(O)CHC(O)CH₃)₂), oxalates (MC₂O₄), hydroxides (M(OH)₂), methoxides (M(OCH₃)₂), and fatty acids, e.g. stearates (M(CH₃(CH₂)₁₅CH₂CO₂)₂); elemental precursors: Zn, Cd, Hg.

### Oxygen Source

In the case where the metal precursor also acts as a source of oxygen (e.g. when the metal precursor is a fatty acid salt such as a metal stearate), no additional oxygen-containing precursor may be required. Where the Group IIB metal precursor does not contain oxygen, the metal precursor may be added in conjunction with an oxygen source that may include, but is not restricted to, a peroxide, a base, an inorganic salt, a coordination compound, an alcohol, or elemental oxygen. Specific examples include, but are not restricted to: peroxides, e.g. H₂O₂; bases such as a hydroxide, e.g. NaOH; inorganic salts such as Na₂O; coordination compounds such as NO₂; alcohols such as primary, secondary or tertiary alcohols.

### Dopant Source(s)

Where the nanoparticles comprise a doped of alloyed Group IIB metal oxide-containing material, one or more dopant sources can be provided by any appropriate compound known to one skilled in the art, including one or more molecular cluster compounds. The dopant source(s) may be added to the reaction solution in the solid, liquid and/or gaseous phases.

### Solvent

Suitable reaction solvents include, but are not restricted to, Lewis base-type coordinating solvents, such as a phosphine (e.g. TOP), a phosphine oxide (e.g. TOPO), or an amine (e.g. HDA), or non-coordinating organic solvents, such as an alkane, an alkene (e.g. 1-octadecene), or heat transfer fluid (e.g. Therminol® 66).

### Capping Agent

When nanoparticle growth is conducted in a non-coordinating solvent, a capping agent must be added to the reaction solution. Such capping agents are typically Lewis bases, including mono- or multi-dentate ligands of the type phosphines (e.g. TOP, triphenolphosphine, t-butylphosphine), phosphine oxides (e.g. TOPO), alkyl phosphonic acids, alkylamines (e.g. HDA, octylamine), arylamines, pyridines, thiols (e.g. octanethiol), a long chain fatty acid, and thiophenes, but a wide range of other agents are available, such as oleic acid and organic polymers that form protective sheaths around the nanoparticles.

The outermost layer (capping agent) of a QD can consist of a coordinated ligand that processes additional functional groups that can be used as chemical linkage to other inorganic, organic or biological material, whereby the functional group is pointing away from the QD surface and is available to bond/react with other available molecules, such as, but not restricted to, primary and/or secondary amines, alcohols, carboxylic acids, azides, hydroxyl group, etc. The outermost layer (capping agent) can also consist of a coordinated ligand that processes a functional group that is polymerisable and can be used to form a polymer around the particle.

The outermost layer (capping agent) can also consist of organic units that are directly bonded to the outermost inorganic layer and can also possess a functional group, not bonded to the surface of the particle, which can be used to form a polymer around the particle, or for further reactions.

### Activating Agent

Optionally, the QD synthesis is conducted in the presence of an activating agent to lower the decomposition temperature of the molecular cluster compound and thus promote nanoparticle growth at lower temperature. Any activating agent known to one skilled in the art may be used including, but not restricted to, an alcohol, *e.g.* octanol, or an amine, *e.g.* HDA, octylamine, *etc.* In preferred embodiments, the activating agent is HDA.

According to a first aspect of the present invention there is provided a method of forming metal oxide nanoparticles, the method comprising: reacting nanoparticle precursors comprising a metal and oxygen in in the presence of a population of molecular cluster compounds.

In the method according to the first aspect of the present invention the molecular cluster compounds and the metal oxide nanoparticles may share a crystallographic phase.The molecular cluster compounds may be fabricated *in situ.* The molecular cluster compounds may be II-VI molecular cluster compounds. Both the molecular cluster compounds and the metal oxide nanoparticle precursors may comprise identical Group IIB metals and oxygen. The molecular cluster compounds may not comprise oxygen. The molecular cluster compounds may not comprise a Group IIB metal identical to a metal of the nanoparticle precursors. The cluster compounds may be oximato clusters. The metal oxide nanoparticles may comprise a Group IIB metal. The metal oxide nanoparticles may comprise ZnO, CdO or HgO. The metal oxide nanoparticles may be doped or alloyed with atoms of the molecular cluster compounds. The metal oxide nanoparticles may be grown on the molecular cluster compounds. The metal oxide nanoparticle precursors may comprise a Group IIB metal and oxygen. The Group IIB metal and oxygen may be added as a single-source precursor. In the method according to the first aspect of the present invention the reacting may comprise reacting the nanoparticle precursors in the presence of an activating agent. The metal oxide nanoparticles may be quantum dots.

A second aspect of the present invention provides a nanoparticle comprising a metal oxide crystalline core disposed upon a molecular cluster compound.

In the second aspect of the present invention the molecular cluster compound and the metal oxide core may share a crystallographic phase. The molecular cluster compound may be II-VI molecular cluster compounds. Both the molecular cluster compound and the metal oxide crystalline core may comprise identical Group IIB metals and oxygen. The molecular cluster compound may not comprise oxygen. The molecular cluster compound may not comprise a Group IIB metal identical to a metal of the metal oxide crystalline core.

### EXAMPLES

The synthesis of Group IIB metal oxide nanoparticles in the presence of a II-VI molecular cluster is illustrated in the following examples.

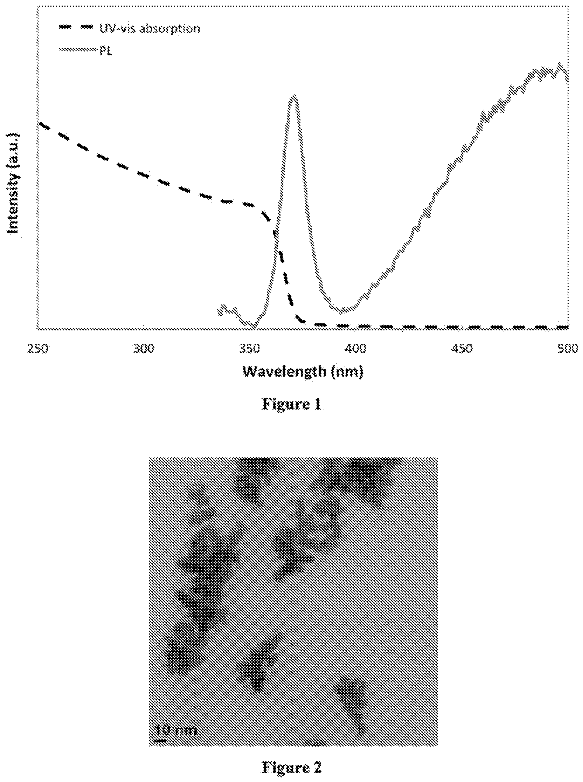

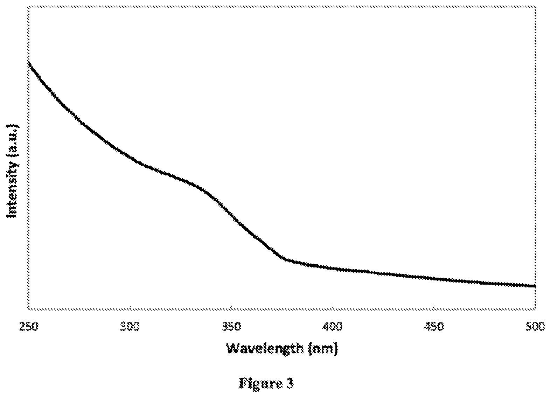

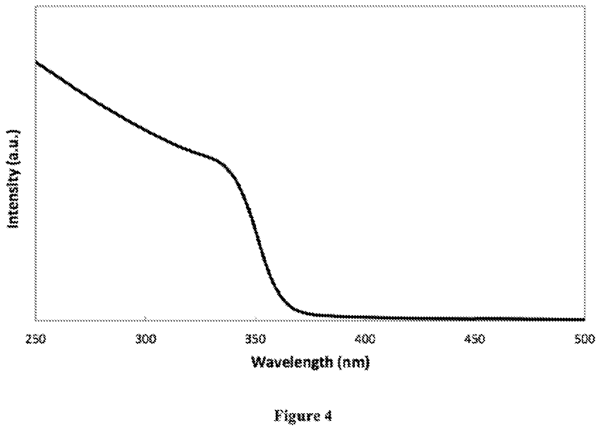

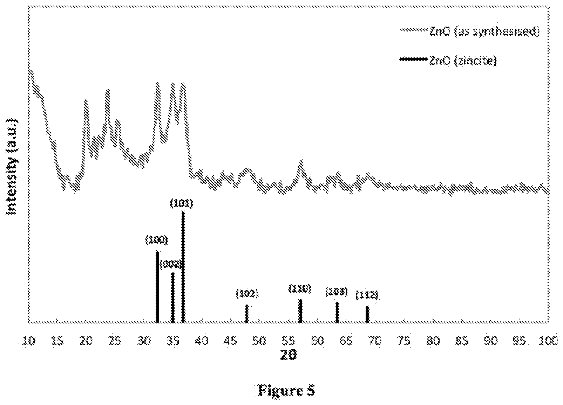

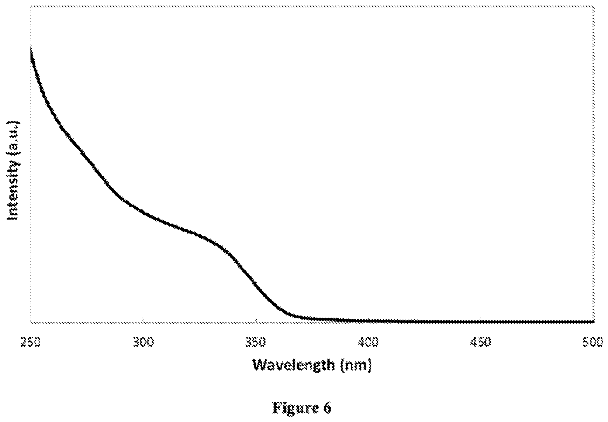

**Preparation of Diaquabis[2-(methoxyimino)propanato]zinc(II) Cluster.** The zinc cluster was prepared as generally described in U.S. Patent No. 7,588,828. Sodium pyruvate (6.8 g, 62 mmol) and methoxylamine hydrochloride (5.12 g, 61 mmol) were mixed in 50 mL water, forming a white cloudy suspension. Sodium carbonate (3.2 g, 30 mmol) was added in portions, resulting in the evolution of gas. Once the gas evolution had finished, leaving a clear solution, zinc nitrate hexahydrate (4.46 g, 15 mmol) was added, then the solution was stirred for 24 hours, during the first 7 hours of which the solution was kept cold at 5°C. A white solid was collected by centrifugation, washed with acetone and dried in a vacuum desiccator overnight. Yield: 1.12 g.
**Example 1: Synthesis of ZnO Nanoparticles in Hexadecylamine.** HDA (10 g, 41 mmol) was degassed under vacuum at 120°C. Diaquabis[2-(methoxyimino)propanato]zinc(II) cluster (100 mg, 0.30 mmol) was added, dissolving immediately to form a clear solution. The temperature was increased to 150°C and held for 30 minutes. The temperature was increased to 200°C and held for 30 minutes, before cooling the solution to room temperature. The product, a white solid, was precipitated with methanol and isolated by centrifugation. UV_{abs} ∼ 355 nm; PLₘₐₓ = 370 nm (Figure 1). Transmission electron microscopy (TEM, Figure 2) imaging reveals pseudo-spherical particles with diameters < 10 nm, consistent with nanoparticles in the quantum dot regime.
**Example 2: Synthesis of ZnO Nanoparticles in Hexadecylamine and Trioctylphosphine Oxide, using Zinc Acetate and Octanol Precursors.** HDA (7 g, 29 mmol) and TOPO (3 g, 7.8 mmol) were degassed under vacuum, at 110°C, for 1 hour. Diaquabis[2-(methoxyimino)propanato]zinc(II) cluster (100 mg, 0.30 mmol) was added and the solution was heated to 200°C. After 35 minutes, the temperature was decreased to 75°C and the solution was annealed for 2 ½ hours, before cooling to room temperature overnight. The solution was reheated to 80°C and zinc(II) acetate (100 mg, 0.55 mmol) was added. The temperature was increased to 180°C and held for 30 minutes. A solution of 1-octanol in 1-octadecene (3.05 M, 2 mL, 6.1 mmol) was injected in slowly. Once the addition was complete, the temperature was held for 30 minutes, before cooling the solution to room temperature. The product, a white solid, was precipitated with methanol and isolated by centrifugation. UV_{abs} ∼ 335 nm (Figure 3).
**Example 3: Concentrated Synthesis of ZnO Nanoparticles in Hexadecylamine and Trioctylphosphine Oxide, using Zinc Acetate and Octanol Precursors.** HDA (7 g, 29 mmol) and TOPO (3 g, 7.8 mmol) were degassed under vacuum, at 110°C, for 30 minutes. At 70°C, diaquabis[2-(methoxyimino)propanato]zinc(II) cluster (200 mg, 0.60 mmol) and zinc(II) acetate (200 mg, 1.1 mmol) were added and the solution, which was subsequently heated to 200°C in 20 minutes. 1-Octanol (1.7 mL, 13 mmol) was injected in, dropwise, over 1 minute. Once the addition was complete, the temperature was held for 40 minutes, before cooling the solution to 70°C. The product, a white/yellow solid, was precipitated with methanol and isolated by centrifugation. UV_{abs} ∼ 338 nm (Figure 4). The X-ray diffraction (XRD) pattern (Figure 5) is consistent with zincite phase ZnO nanoparticles. *N.B.* The low angle (2θ < 30°) reflections correspond to the capping agent.
**Example 4: Synthesis of ZnO Nanoparticles in Hexadecylamine and Trioctylphosphine Oxide.** HDA (7 g, 29 mmol) and TOPO (3 g, 7.8 mmol) were degassed under vacuum, at 110°C, for 30 minutes. At 70°C, diaquabis[2-(methoxyimino)propanato]zinc(II) cluster was added and the solution was subsequently heated to 200°C in 20 minutes. The temperature was held for 40 minutes, before cooling the solution to 70°C. The product, a white solid, was precipitated with methanol and isolated by centrifugation. UV_{abs} ∼ 335 nm (Figure 6).

## Claims

1. A method of forming Group IIB metal oxide nanoparticles, the method comprising:
reacting nanoparticle precursors comprising a Group IIB metal and oxygen in in the presence of a population of IIB-VIB molecular cluster compounds.

2. The method as recited in claim 1, wherein the molecular cluster compounds and the metal oxide nanoparticles share a crystallographic phase.

3. The method as recited in claim 1, wherein the molecular cluster compounds are fabricated *in situ.*

4. The method as recited in claim 1, wherein both the molecular cluster compounds and the metal oxide nanoparticle precursors comprise identical Group IIB metals and oxygen.

5. The method as recited in claim 1, wherein the molecular cluster compounds do not comprise oxygen.

6. The method as recited in claim 1, wherein the molecular cluster compounds do not comprise a Group IIB metal identical to a Group IIB metal of the nanoparticle precursors.

7. The method as recited in claim 1, wherein the cluster compounds are oximato clusters.

8. The method as recited in claim 1, wherein the metal oxide nanoparticles comprise ZnO, CdO or HgO.

9. The method as recited in claim 1, wherein the metal oxide nanoparticles are:
(i) doped or alloyed with atoms of the molecular cluster compounds; or
(ii) grown on the molecular cluster compounds.

10. The method as recited in claim 1, wherein the Group IIB metal and oxygen are added as a single-source precursor.

11. The method as recited in claim 1, wherein the reacting comprises reacting the nanoparticle precursors in the presence of an activating agent for lowering the decomposition temperature of the molecular cluster compound.

12. The method as recited in claim 1, wherein the metal oxide nanoparticles are quantum dots.

13. A nanoparticle comprising a Group IIB metal oxide crystalline core disposed upon a IIB-VIB molecular cluster compound.

14. The nanoparticle as recited in claim 13, wherein:
(i) the molecular cluster compound and the metal oxide core share a crystallographic phase; or
(ii) both the molecular cluster compound and the metal oxide crystalline core comprise identical Group IIB metals and oxygen; or
(iii) the molecular cluster compound does not comprise oxygen; or
(iv) the molecular cluster compound does not comprise a Group IIB metal identical to a Group IIB metal of the metal oxide crystalline core.

## Patentansprüche

1. Verfahren zum Bilden von Nanopartikeln von Oxid von Metallen der Gruppe IIB, wobei das Verfahren Folgendes umfasst:
das Reagieren von Nanopartikelvorläufern umfassend ein Metall der Gruppe IIB und Sauerstoff in Gegenwart einer Population von molekularen IIB-VIB-Clusterverbindungen.

2. Verfahren wie in Anspruch 1 aufgeführt, wobei die molekularen Clusterverbindungen und die Metalloxidnanopartikel eine kristallographische Phase gemeinsam haben.

3. Verfahren wie in Anspruch 1 aufgeführt, wobei die molekularen Clusterverbindungen in situ gefertigt werden.

4. Verfahren wie in Anspruch 1 aufgeführt, wobei sowohl die molekularen Clusterverbindungen als auch die Metalloxidnanopartikelvorläufer identische Metalle der Gruppe IIB und Sauerstoff umfassen.

5. Verfahren wie in Anspruch 1 aufgeführt, wobei die molekularen Clusterverbindungen keinen Sauerstoff umfassen.

6. Verfahren wie in Anspruch 1 aufgeführt, wobei die molekularen Clusterverbindungen kein Metall der Gruppe IIB umfassen, das einem Metall der Gruppe IIB der Nanopartikelvorläufer identisch ist.

7. Verfahren wie in Anspruch 1 aufgeführt, wobei die Clusterverbindungen Oximatcluster sind.

8. Verfahren wie in Anspruch 1 aufgeführt, wobei die Metalloxidnanopartikel ZnO, CdO oder HgO umfassen.

9. Verfahren wie in Anspruch 1 aufgeführt, wobei die Metalloxidnanopartikel Folgendes sind:
(i) mit Atomen der molekularen Clusterverbindungen dotiert oder legiert; oder
(ii) auf den molekularen Clusterverbindungen gezüchtet.

10. Verfahren wie in Anspruch 1 aufgeführt, wobei das Metall der Gruppe IIB und Sauerstoff als Einquellenvorläufer zugegeben werden.

11. Verfahren wie in Anspruch 1 aufgeführt, wobei das Reagieren das Reagieren der Nanopartikelvorläufer in Gegenwart eines aktivierenden Mittels zum Reduzieren der Zersetzungstemperatur der molekularen Clusterverbindung umfasst.

12. Verfahren wie in Anspruch 1 aufgeführt, wobei die Metalloxidnanopartikel Quantenpunkte sind.

13. Nanopartikel umfassend einen kristallinen Kern aus Oxid eines Metalls der Gruppe IIB, der auf einer molekularen IIB-VIB-Clusterverbindung abgesetzt ist.

14. Nanopartikel wie in Anspruch 13 aufgeführt, wobei:
(i) die molekulare Clusterverbindung und der Metalloxidkern eine kristallographische Phase gemeinsam haben; oder
(ii) sowohl die molekulare Clusterverbindung als auch der kristalline Metalloxidkern identische Metalle der Gruppe IIB und Sauerstoff umfassen; oder
(iii) die molekulare Clusterverbindung keinen Sauerstoff umfasst; oder
(iv) die molekulare Clusterverbindung kein Metall der Gruppe IIB umfasst, das mit einem Metall der Gruppe IIB des kristallinen Metalloxidkerns identisch ist.

## Revendications

1. Procédé de formation de nanoparticules d'oxyde métallique du groupe IIB, le procédé comprenant:
la réaction de précurseurs de nanoparticules comprenant un métal du groupe IIB et de l'oxygène en présence d'une population de composés des groupes moléculaires IIB à VIB.

2. Procédé tel qu'énoncé selon la revendication 1, les composés des groupes moléculaires et les nanoparticules d'oxyde métallique partageant une phase cristallographique.

3. Procédé tel qu'énoncé selon la revendication 1, les composés des groupes moléculaires étant fabriqués *in situ.*

4. Procédé tel qu'énoncé selon la revendication 1, à la fois les composés des groupes moléculaires et les précurseurs de nanoparticules d'oxyde métallique comprenant des métaux identiques du groupe IIB et de l'oxygène.

5. Procédé tel qu'énoncé selon la revendication 1, les composés des groupes moléculaires ne comprenant pas d'oxygène.

6. Procédé tel qu'énoncé selon la revendication 1, les composés des groupes moléculaires ne comprenant pas de métal du groupe IIB identique à un métal du groupe IIB des précurseurs de nanoparticules.

7. Procédé tel qu'énoncé selon la revendication 1, les composés des groupes étant des groupes oximato.

8. Procédé tel qu'énoncé selon la revendication 1, les nanoparticules d'oxyde métallique comprenant du ZnO, CdO ou HgO.

9. Procédé tel qu'énoncé selon la revendication 1, les nanoparticules d'oxyde métallique étant:
(i) dopées ou en alliage avec des atomes des composés des groupes moléculaires; ou
(ii) cultivées sur les composés des groupes moléculaires.

10. Procédé tel qu'énoncé selon la revendication 1, le métal du groupe IIB et l'oxygène étant ajoutés comme précurseur de source unique.

11. Procédé tel qu'énoncé selon la revendication 1, la réaction comprenant la réaction des précurseurs de nanoparticules en présence d'un agent d'activation pour réduire la température de décomposition du composé du groupe moléculaire.

12. Procédé tel qu'énoncé selon la revendication 1, les nanoparticules d'oxyde métallique étant des points quantiques.

13. Nanoparticule comprenant un noyau cristallin d'oxyde métallique du groupe IIB disposé sur un composé du groupe moléculaire IIB à VIB.

14. Nanoparticule telle qu'énoncée selon la revendication 13:
(i) le composé du groupe moléculaire et le noyau d'oxyde métallique partageant une phase cristallographique; ou
(ii) à la fois le composé du groupe moléculaire et le noyau cristallin d'oxyde métallique comprenant des métaux identiques du groupe IIB et de l'oxygène; ou
(iii) le composé du groupe moléculaire ne comprenant pas d'oxygène; ou
(iv) le composé du groupe moléculaire ne comprenant pas de métal du groupe IIB identique à un métal du groupe IIB du noyau cristallin d'oxyde métallique.
